# EUROPEAN PATENT APPLICATION

(11) **EP 4 503 331 A1**
(43) Date of publication of application: **05.02.2025**
(21) Application number: 23775325.6
(22) Date of filing: 23.03.2023
(51) Int. Cl.: H01Q 1/38, H01L 23/66, H01L 23/29, H01L 23/31, H01L 23/52

(54) **ANTENNA SUBSTRATE**

(30) Priority: 25.03.2022 KR 20220037623
(71) Applicant: LG INNOTEK CO. LTD, Gangseo-gu Seoul 07796 (KR)
(72) Inventor: LEE, Dong Hwa, Seoul 07796 (KR); PARK, Jae Man, Seoul 07796 (KR); HEO, Seon, Seoul 07796 (KR)
(74) Representative: DREISS Patentanwälte PartG mbB
(86) International application number: PCT/KR2023/003863
(87) International publication number: WO 2023/182829

(57) **Abstract**

An antenna substrate according to an embodiment includes an insulating layer; a circuit layer disposed on the insulating layer; and a protective layer disposed on the insulating layer and the circuit layer, wherein the protective layer is disposed to overlap with the circuit layer in a vertical direction and a horizontal direction, and has a permittivity (Dk) of between 20 and 40.

## Description

### [Technical Field]

An embodiment relates to an antenna substrate and an antenna device including the same.

### [Background Art]

Recently, efforts have been made to develop improved 5G (5th generation) communication systems or pre-5G communication systems to meet the demand for wireless data traffic.

The 5G communication system uses ultra-high frequency (mm-Wave) bands (sub 6 GHz, 28 GHz, 38 GHz or higher frequencies) to achieve high data transfer rates. This high frequency band is called mm-Wave due to the length of the wavelength.

In order to alleviate the path loss of radio waves in the ultra-high frequency band and increase the transmission distance of radio waves, integration technologies such as beamforming, massive MIMO, and array antenna are being developed in 5G communication systems.

Considering that these frequency bands can consist of hundreds of active antennas of wavelengths, antenna systems can be relatively large.

This means that a plurality of boards that make up an active antenna system, that is, an antenna substrate, an antenna feed board, a transceiver board, a and baseband board, must be integrated into one compact unit.

Meanwhile, a technology has been developed to form A resonant frequency of an antenna by using a dielectric layer having a high permittivity.

Specifically, a dielectric layer having a high permittivity is disposed on an upper portion or lower portion of a conventional antenna substrate. Then, an antenna patch included in the antenna substrate can resonate at a specific resonant frequency band by using the dielectric layer having the high permittivity.

However, the dielectric layer having the high permittivity applied to the conventional antenna substrate has a structure including an epoxy mold compound (EMC) formed using a mold process.

At this time, the conventional antenna substrate including the epoxy mold compound has a problem of increasing an overall thickness. In addition, the conventional antenna substrate has various problems in the process of forming the EMC layer.

### [Disclosure]

### [Technical Problem]

The embodiment provides an antenna substrate having a novel structure and an antenna device including the same.

In addition, the embodiment provides an antenna substrate capable of shifting a resonant frequency while providing a slim substrate and an antenna device including the same.

In addition, the embodiment provides an antenna substrate capable of reducing a separation distance between a plurality of antenna patches and an antenna device including the same.

Technical problems to be solved by the proposed embodiments are not limited to the above-mentioned technical problems, and other technical problems not mentioned may be clearly understood by those skilled in the art to which the embodiments proposed from the following descriptions belong.

### [Technical Solution]

An antenna substrate according to an embodiment includes an insulating layer; a circuit layer disposed on the insulating layer; and a protective layer disposed on the insulating layer and the circuit layer, wherein the protective layer is disposed to overlap with the circuit layer in a vertical direction and a horizontal direction, and has a permittivity (Dk) of between 20 and 40.

In addition, the circuit layer is an antenna unit disposed on an uppermost side of the antenna substrate, and the protective layer is a solder resist disposed on the insulating layer and the antenna unit.

In addition, the protective layer includes: a resin; and a filler disposed in the resin and composed of at least one of TiO₂, Al₂O₃, BaTiO₃, and CaTiO₃.

In addition, a content of the filler in the protective layer satisfies a range of 35 wt% to 85 wt%.

In addition, the circuit layer includes a plurality of antenna unit disposed on the insulating layer and spaced apart from each other, and two antenna units adjacent to each other among the plurality of antenna units are spaced apart from each other by a distance between 0.5 mm and 1.5 mm.

In addition, the plurality of antenna units are disposed alternately or zigzag on the insulating layer in a diagonal direction, and the distance is a separation distance in the diagonal direction between two antenna units arranged adjacent to each other.

In addition, the protective layer includes: a first region overlapping the circuit layer in a thickness direction; and a second region excluding the first region, and wherein a thickness of the first region of the protective layer satisfies a range of 5 µm to 25 µm.

In addition, an upper surface of the first region of the protective layer has a same height as the upper surface of the second region of the protective layer.

In addition, an upper surface of the first region of the protective layer has a step from an upper surface of the second region of the protective layer.

Meanwhile, an antenna substrate according to an embodiment includes an insulating layer; a circuit layer disposed on the insulating layer; a first protective layer disposed on the insulating layer; and a second protective layer disposed on the circuit layer, wherein the first protective layer has a first permittivity, wherein the second protective layer has a second permittivity greater than the first permittivity, and wherein the second permittivity has a range of 4 to 14 times that of the first permittivity.

In addition, the circuit layer is an antenna unit disposed on an uppermost side of the antenna substrate, and each of the first and second protective layers is a solder resist disposed on the insulating layer or the antenna unit.

In addition, the first protective layer is disposed on an upper surface of the insulating layer and the circuit layer, and the second protective layer is disposed in a region overlapping the circuit layer in a thickness direction among an upper surface of the first protective layer.

In addition, a width of the second protective layer is greater than a width of the circuit layer.

In addition, the circuit layer includes a plurality of antenna units disposed on the insulating layer, and the second protective layer includes a plurality of patterns vertically overlapping the plurality of antenna units.

In addition, the first protective layer includes an opening overlapping the circuit layer in a thickness direction, and the second protective layer is disposed in direct contact with an upper surface of the circuit layer in the opening of the first protective layer.

In addition, a width of the opening of the first protective layer is greater than a width of the circuit layer, and the second protective layer is disposed surrounding upper and side surfaces of the circuit layer.

In addition, an upper surface of the first protective layer is located lower than an upper surface of the second protective layer, and at least a part of the second protective layer is disposed on the upper surface of the first protective layer.

In addition, the first protective layer includes a first filler, the second protective layer includes a second filler of a material different from the first filler, and the second filler includes at least one of TiO₂, Al₂O₃, BaTiO₃, and CaTiO₃.

In addition, the first filler in the first protective layer has a first content, the second filler in the second protective layer has a second content greater than the first content, and the second content satisfies a range of 35wt% to 85wt%.

In addition, the circuit layer includes a plurality of antenna units disposed alternately or zigzag on the insulating layer in a diagonal direction, and a distance in the diagonal direction between two antenna units arranged adjacent to each other among the plurality of antenna units satisfies a range of 0.5mm to 1.5mm.

### [Advantageous Effects]

An antenna substrate of an embodiment includes an insulating layer, a circuit layer disposed on the insulating layer, and a protective layer. At this time, the protective layer includes a first region that vertically overlaps the circuit layer and a second region that does not vertically overlap the circuit layer. The protective layer has a permittivity in a range of 20 to 40. The first region of the protective layer may shift a resonance frequency of a radiation beam radiated by the circuit layer. In addition, the second region of the protective layer may function to reduce a distance between a plurality of antenna units constituting the circuit layer.

Accordingly, the embodiment may remove an EMC layer included in the antenna substrate of a comparative example, thereby solving problems of the EMC layer.

In addition, in an embodiment, a size (specifically, a planar area) of the circuit layer may be reduced by allowing the resonance frequency to be shifted using the first region of the protective layer. Accordingly, the embodiment may reduce a width of the antenna substrate in a horizontal direction. In addition, the embodiment may integrate the circuit layer included in the antenna substrate. In addition, the embodiment can increase a number of antenna units disposed in a same area compared to the comparative example. In addition, the embodiment may miniaturize an electronic device including an antenna substrate.

In addition, the embodiment may reduce a distance between a plurality of antenna units by using the second region of the protective layer. Specifically, the embodiment can prevent signal interference that may occur between the plurality of antenna units even when the distance between the plurality of antenna units is reduced compared to the comparative example. Accordingly, the embodiment may prevent mutual signal interference of a plurality of antenna units, thereby improving antenna characteristics and performance. In addition, the embodiment may integrate circuit layers included in an antenna substrate. In addition, the embodiment may increase the number of antenna units disposed in a same area as compared to the comparative example.

Meanwhile, the circuit layer of the embodiment includes a plurality of antenna units disposed on the insulating layer. In this case, the embodiment uses the first region and the second region of the protective layer to allow the plurality of antenna units to be disposed alternately or in a zigzag pattern on the insulating layer. That is, the embodiment can further improve the integration of the antenna units by arranging a plurality of antenna units alternately or zigzag on the insulating layer. Accordingly, the embodiment can further improve the antenna characteristics and performance.

Meanwhile, the protective layer of the embodiment includes a first protective layer and a second protective layer. The first protective layer is a protective layer having a relatively low permittivity. In addition, the second protective layer is a protective layer having a relatively high permittivity.

In addition, the second protective layer may be disposed in a region vertically overlapping the circuit layer. In addition, the first protective layer may be selectively disposed in a region where the second protective layer is not disposed. Accordingly, the embodiment may maximize antenna characteristics and performance while minimizing an arrangement area of the second protective layer.

### [Description of Drawings]

FIG. 1 is a view showing an antenna substrate according to a comparative example.
FIG. 2 is a view for schematically explaining an arrangement structure of an antenna substrate according to an embodiment.
FIG. 3 is a cross-sectional view showing the antenna substrate of FIG. 2.
FIG. 4 is a cross-sectional view showing a part of a layer of an antenna substrate according to a first embodiment.
FIG. 5 is a plan view showing a part of a layer of an antenna substrate of FIG. 4.
FIG. 6 is a view for explaining characteristics of a protective layer applied to the first embodiment.
FIG. 7 is a view for explaining resonance frequency characteristics of an antenna substrate according to a first embodiment.
FIG. 8 is a view for comparing a circuit layer according to a first embodiment with a circuit layer of a comparative example.
FIG. 9 is a view showing a modified example of an arrangement structure of a circuit layer according to a first embodiment.
FIG. 10 is a view showing an antenna substrate according to a second embodiment.
FIG. 11 is a view showing an antenna substrate according to a third embodiment.
FIG. 12 is a view showing an antenna substrate according to a fourth embodiment.
FIG. 13 is a view showing an antenna substrate according to a fifth embodiment.
FIG. 14 is a view showing an antenna substrate according to a sixth embodiment.
FIG. 15 is a view showing an antenna substrate according to a seventh embodiment.
FIG. 16 is a view showing an antenna substrate according to an eighth embodiment.
FIG. 17 is a view showing an antenna substrate according to a ninth embodiment.
FIG. 18 is a view showing an antenna substrate according to a tenth embodiment.
FIG. 19 is a view showing an antenna device according to a first embodiment.
FIG. 20 is a view showing an antenna device according to a second embodiment.

### [Modes of the Invention]

Hereinafter, embodiments of the present invention will be described in detail with reference to the accompanying drawings.

However, the spirit and scope of the present invention is not limited to a part of the embodiments described, and may be implemented in various other forms, and within the spirit and scope of the present invention, one or more of the elements of the embodiments may be selectively combined and redisposed.

In addition, unless expressly otherwise defined and described, the terms used in the embodiments of the present invention (including technical and scientific terms may be construed the same meaning as commonly understood by one of ordinary skill in the art to which this invention belongs, and the terms such as those defined in commonly used dictionaries may be interpreted as having a meaning that is consistent with their meaning in the context of the relevant art.

Further, the terms used in the embodiments of the present invention are for describing the embodiments and are not intended to limit the present invention. In this specification, the singular forms may also include the plural forms unless specifically stated in the phrase, and may include at least one of all combinations that may be combined in A, B, and C when described in "at least one (or more) of A (and), B, and C".

Further, in describing the elements of the embodiments of the present invention, the terms such as first, second, A, B, (a), and (b) may be used. These terms are only used to distinguish the elements from other elements, and the terms are not limited to the essence, order, or order of the elements. In addition, when an element is described as being "connected", "coupled", or "contacted" to another element, it may include not only when the element is directly "connected" to, "coupled" to, or "contacted" to other elements, but also when the element is "connected", "coupled", or "contacted" by another element between the element and other elements.

In addition, when described as being formed or disposed "on (over)" or "under (below)" of each element, the "on (over)" or "under (below)" may include not only when two elements are directly connected to each other, but also when one or more other elements are formed or disposed between two elements. Further, when expressed as "on (over)" or "under (below)", it may include not only the upper direction but also the lower direction based on one element.

Before the description of the antenna substrate and the antenna device including the same of a present embodiment, an antenna substrate according to the comparative example will be described.

### -Comparative Example-

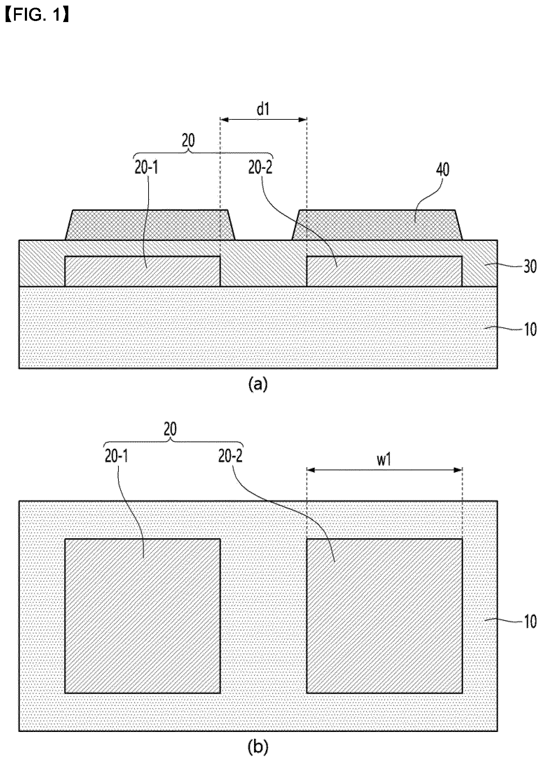

FIG. 1 is a view showing an antenna substrate according to a comparative example.

FIG. 1(a) is a cross-sectional view of an antenna substrate according to a comparative example, and FIG. 1(b) is a plan view of some components of the antenna substrate according to a comparative example.

Referring to FIG. 1(a) and FIG. 1(b), the antenna substrate of the comparative example includes an insulating layer 10.

In addition, the antenna substrate of the comparative example includes a circuit layer 20 disposed on the insulating layer 10. The circuit layer 20 refers to an antenna patch disposed on the insulating layer 10.

In addition, in the antenna substrate of the comparative example, the insulating layer 10 has a plurality of layer structures. Accordingly, the circuit layer 20 is disposed on each insulating layer having the plurality of layer structures. In addition, the circuit layer 20 of FIG. 1 shows a circuit layer disposed on an uppermost side of an antenna substrate among a plurality of circuit layers.

The antenna substrate of the comparative example includes a protective layer 30 disposed on the insulating layer 10. The protective layer 30 is a solder resist. The protective layer 30 of the comparative example has a permittivity Dk between 3.0 and 5.0.

In this case, in the comparative example, the circuit layer 20 is an antenna patch that resonates in a specific resonance frequency band. In this case, the antenna substrate of the comparative example includes a dielectric layer 40 disposed on the protective layer 30 so that the circuit layer 20 resonates in a specific resonance frequency band. In this case, the dielectric layer 40 of the comparative example has a permittivity Dk in a range of 10 to 20. And, in the comparative example, a radiation beam may be radiated by the circuit layer 20 in a target resonance frequency band by using the dielectric layer 40.

In this case, the dielectric layer 40 of the comparative example is an epoxy mold compound layer (EMC layer) formed by using a mold process. In this case, there is a limit to a minimum thickness of the EMC layer that may be formed by using the mold process. For example, the EMC layer of the comparative example has a thickness of 300 µm or more. Accordingly, there is a problem that an overall thickness of the antenna substrate of the comparative example is increased by a thickness of the dielectric layer 40. Accordingly, there is a problem that a thickness of the antenna device to which the antenna substrate of the comparative example is applied is increased, thereby increasing a thickness of an electronic device corresponding to the antenna device.

In addition, the dielectric layer 40 having a high permittivity is more expensive than the dielectric layer having a lower permittivity. Accordingly, the antenna substrate of the comparative example has a relatively thick thickness of the dielectric layer 40, and accordingly, there is a problem in that a manufacturing cost of the antenna substrate is increased.

In addition, when forming an EMC layer corresponding to the dielectric layer (40) using a mold process, there is a problem that a mold resin flows out of the mold due to the characteristics of a manufacturing process, resulting in a decrease in yield.

Meanwhile, a plurality of circuit layers 20 of the comparative example may be disposed on the insulating layer 10 while being spaced apart from each other in a longitudinal direction or a width direction. For example, the circuit layer 20 includes a first antenna patch 20-1 and a second antenna patch 20-2, which are spaced apart from each other. In this case, the protective layer 30 is disposed between the first antenna patch 20-1 and the second antenna patch 20-2 in the comparative example. Specifically, the dielectric layer 40 of the comparative example does not overlap the first antenna patch 20-1 and the second antenna patch 20-2 in a horizontal direction.

Accordingly, the first antenna patch 20-1 and the second antenna patch 20-2 in the comparative example are spaced apart from each other by a predetermined distance d1. In this case, the first antenna patch 20-1 and the second antenna patch 20-2 in the comparative example are spaced apart from each other by a distance d1 of 1.7 mm or more. That is, in the comparative example, only the protective layer 30 having a relatively low permittivity is disposed between the first antenna patch 20-1 and the second antenna patch 20-2. Accordingly, in the comparative example, the first antenna patch 20-1 and the second antenna patch 20-2 are arranged with a distance of 1.7 mm or more, thereby resolving mutual interference between the first antenna patch 20-1 and the second antenna patch 20-2. In this case, in the comparative example, a space in which the circuit layer 20 is disposed increases due to the distance d1 between the first antenna patch 20-1 and the second antenna patch 20-2. Accordingly, in the comparative example, a width of the antenna substrate in the horizontal direction is increased.

On the other hand, in the comparative example, instead of the dielectric layer 40 having a high permittivity above, any one of the insulating layers having a plurality of layer structures is applied as a prepreg having a high permittivity. However, if the insulating layer is formed of a prepreg having a high permittivity, there is a problem that warpage characteristics are deteriorated. For example, in a process of laminating a plurality of insulating layers in a manufacturing process of the antenna substrate, the antenna substrate of the comparative example has a problem of deteriorating the warpage characteristics of the antenna substrate due to a difference in permittivity between the prepreg having a high permittivity and the insulating layers other than the same.

In addition, when an antenna substrate is manufactured, including a prepreg with a high permittivity, OUT-GAS that is harmful to static electricity or products may occur, and this causes physical or electrical reliability problems such as voids.

On the other hand, in a case of antenna devices applied to 5G communication systems, more data is being transmitted and received than in conventional communication systems. In order to transmit and receive as much data as above, a battery capacity must increase as battery consumption increases. In addition, in order to increase the battery capacity, a size of the battery must increase and a battery arrangement space must increase accordingly.

Accordingly, in conventional 5G communication systems, a thickness of the antenna package substrate is decreasing to maintain a size of the antenna device (e.g., a mobile terminal) while increasing a size of the battery.

At this time, there is a limit to reducing a thickness of the insulating layer or a thickness of the circuit layer in order to reduce a thickness of the antenna package substrate. In addition, if the thickness of the antenna pattern is recklessly reduced, there is a problem in that communication performance decreases (e.g., a transmission strength of a transmission signal or a reception strength of a reception signal decreases).

Accordingly, the embodiment may reduce an area in which the antenna patch is disposed on the antenna substrate while reducing a thickness of the antenna substrate compared to the comparative example.

Hereinafter, an antenna substrate according to an embodiment will be described.

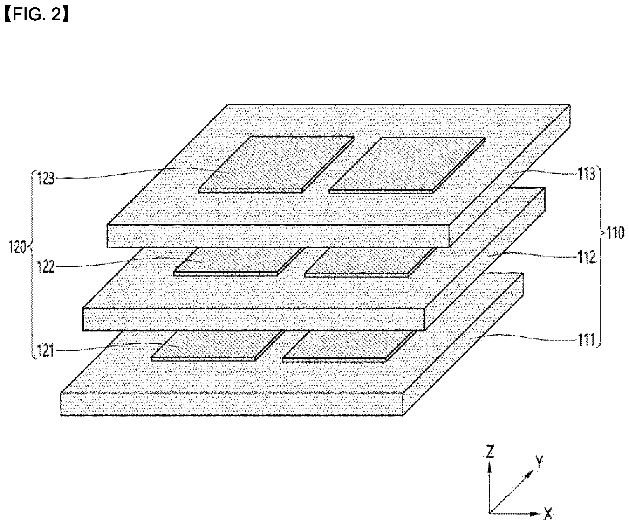

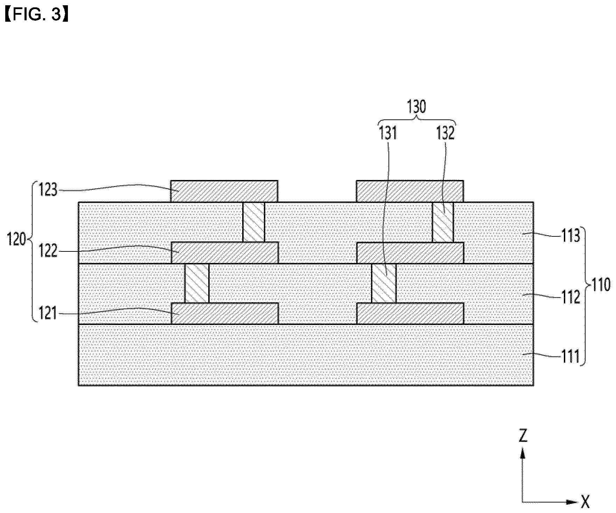

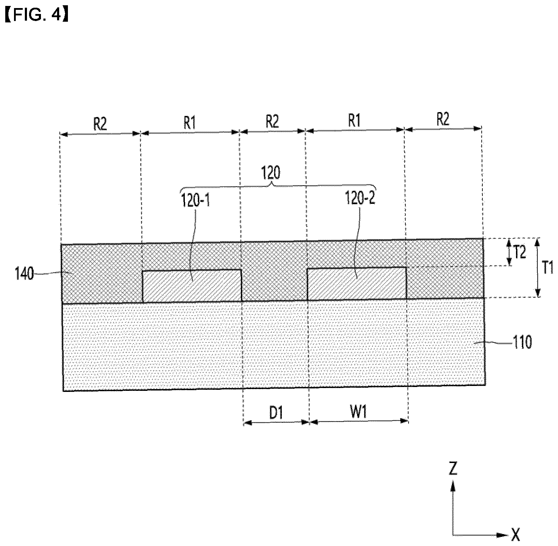

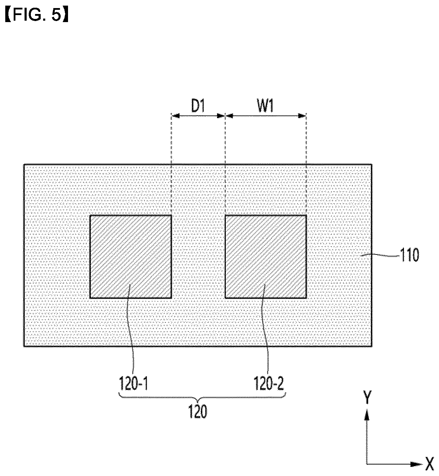

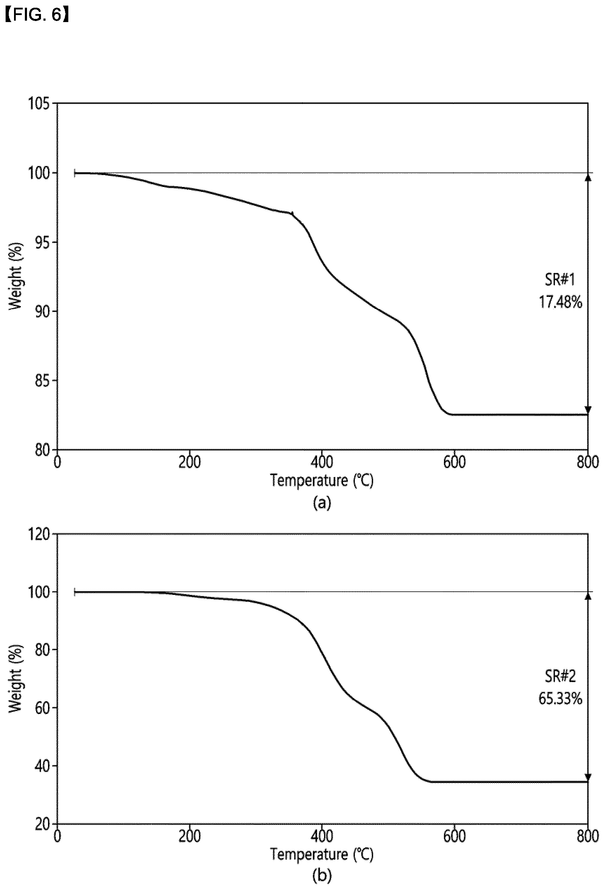

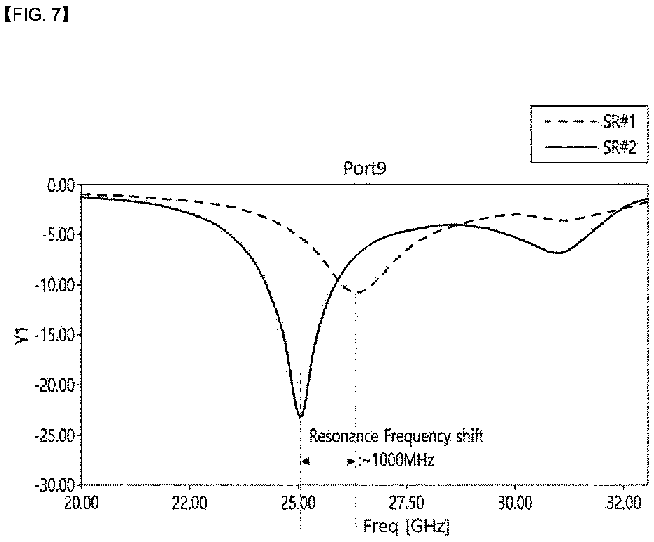

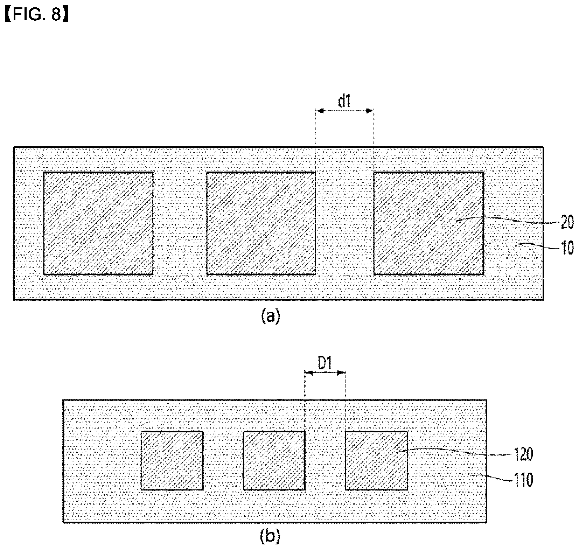

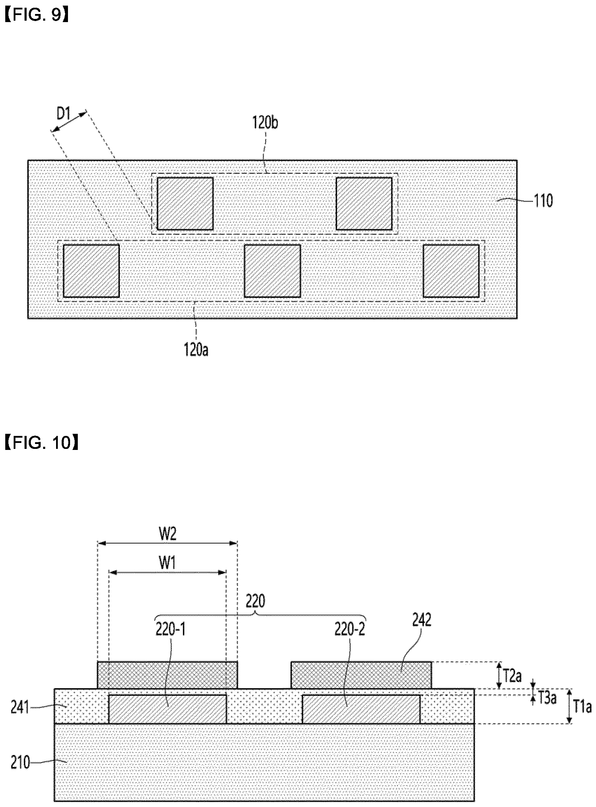

FIG. 2 is a view for schematically explaining an arrangement structure of an antenna substrate according to an embodiment, FIG. 3 is a cross-sectional view showing the antenna substrate of FIG. 2, FIG. 4 is a cross-sectional view showing a part of a layer of an antenna substrate according to a first embodiment, FIG. 5 is a plan view showing a part of a layer of an antenna substrate of FIG. 4, FIG. 6 is a view for explaining characteristics of a protective layer applied to the first embodiment, FIG. 7 is a view for explaining resonance frequency characteristics of an antenna substrate according to a first embodiment, FIG. 8 is a view for comparing a circuit layer according to a first embodiment with a circuit layer of a comparative example, and FIG. 9 is a view showing a modified example of an arrangement structure of a circuit layer according to a first embodiment.

Hereinafter, an antenna substrate according to a first embodiment will be described in detail with reference to FIGS. 2 to 9.

An antenna substrate of an embodiment may include an insulating layer 110, a circuit layer 120, a through electrode 130, and a protective layer 140.

The insulating layer 110 may be provided for feeding and supporting the antenna substrate. The insulating layer 110 may have a flat plate structure. The insulating layer 110 may be formed of a single layer, and alternatively, may include a plurality of layers in which a plurality of layers are stacked.

The insulating layer 110 may include a first insulating layer 111, a second insulating layer 112, and a third insulating layer 113. However, the embodiment is not limited thereto. For example, the insulating layer 110 may have a number of layers of two or less layers, or alternatively, may have a number of layers of four or more layers.

The insulating layer 110 may include a prepreg (PPG). The prepreg may be formed by impregnating a fiber layer in a form of a fabric sheet such as a glass fabric woven from a glass fiber yarn with epoxy resin or the like and then performing thermal compression. However, the embodiment is not limited thereto, and the prepreg constituting the insulating layer 110 may include a fiber layer in a form of a fabric sheet woven from carbon fiber yarn.

For example, the insulating layer 110 may be rigid or flexible.

Each insulating layer constituting the insulating layer 110 may have a thickness in a range of 10 µm to 60 µm. Preferably, each insulating layer constituting the insulating layer 110 may have a thickness in a range of 12 µm to 50 µm. More preferably, each insulating layer constituting the insulating layer 110 may have a thickness of 15 µm to 40 µm.

If a thickness of each insulating layer constituting the insulating layer 110 is less than 10 µm, a circuit layer included in the antenna substrate may not be stably protected. If a thickness of each insulating layer constituting the insulating layer 110 exceeds 60 µm, a thickness of the antenna substrate, a thickness of the antenna device, and a thickness of the electronic device may increase. If a thickness of each insulating layer constituting the insulating layer 110 exceeds 60 µm, a thickness of the circuit layer and a thickness of the through electrode may increase correspondingly. In addition, if the thickness of the circuit layer and the thickness of the through electrode increase, signal transmission loss may increase.

The circuit layer 120 may be disposed on a surface of the insulating layer 110. The circuit layer 120 may mean a circuit layer that functions as an antenna. For example, the circuit layer 120 may mean an antenna pattern layer. For example, the circuit layer 120 may mean an antenna patch.

The circuit layer 120 may have a plurality of layers.

For example, the circuit layer 120 may include a first circuit layer 121 on the first insulating layer 111, a second circuit layer 122 on the second insulating layer 112, and a third circuit layer 123 on the third insulating layer 113.

At this time, the circuit layer 120 is described in the drawing as including the first to third circuit layers 121, 122, and 123, but is not limited thereto.

The circuit layer 120 may include a ground layer (not shown) for grounding, a feed layer (not shown) for feeding, and a radiation layer (not shown) for radiating signals. For example, the ground layer, the feed layer, and the radiation layer may be disposed on different insulating layers.

However, the embodiment is not limited thereto, and the circuit layer corresponding to an antenna unit among the circuit layers 120 of the embodiment may be disposed on a surface of any one of the plurality of insulating layers and may not be disposed on a surface of the at least one other insulating layer. For example, when the insulating layer of the embodiment includes first to third insulating layers, the circuit layer 120 may be disposed on an upper surface or a lower surface of any one of the first to third insulating layers and may not be disposed on an upper surface or a lower surface of the at least one other insulating layer.

The circuit layer 120 of an embodiment may be provided to an antenna substrate for transmitting and receiving signals. The circuit layer 120 may transmit and receive signals in a predetermined resonance frequency band. For example, the circuit layer 120 may be operated in a predetermined resonance frequency band to transmit and receive electromagnetic waves. The circuit layer 120 may be operated by power supplied from a feeding unit (not shown).

In this case, the circuit layer 120 may resonate in at least one resonant frequency band.

For example, the circuit layer 120 may be a resonant antenna resonating in a first frequency band of 24.03 GHz to 25.81 GHz or a second frequency band of 27.07 GHz to 28.80 GHz.

As another example, the circuit layer 120 may be a dual resonant antenna that resonates in different resonant frequency bands. For example, the circuit layer 120 may be a dual resonant antenna that resonates in a first frequency band of 24.03 GHz to 25.81 GHz and a second frequency band of 27.07 GHz to 28.80 GHz, respectively.

Meanwhile, the circuit layer 120 of FIG. 4 may refer to an antenna patch disposed at an outermost side (clearly, at an uppermost side or a lowermost side) of the antenna substrate among a plurality of circuit layers. Specifically, the circuit layer 120 according to an embodiment may be disposed on different insulating layers, respectively, and differently, may be disposed only on one insulating layer. In this case, an arrangement structure of the circuit layer 120 may be determined based on a resonance frequency band.

The circuit layer 120 may be formed on the insulating layer 110 to have a thickness of 10 µm to 25 µm. Preferably, the circuit layer 120 may be formed on the insulating layer 110 to have a thickness of 12 µm to 23 µm. More preferably, the circuit layer 120 may be formed on the insulating layer 110 to have a thickness of 15 µm to 20 µm.

The circuit layer 120 may include a conductive material. For example, the circuit layer 120 may include at least one metal material selected from gold (Au), silver (Ag), platinum (Pt), titanium (Ti), tin (Sn), copper (Cu), and zinc (Zn). Preferably, the circuit layer 120 may be formed of copper (Cu) having high electrical conductivity and relatively low cost.

On the other hand, the circuit layer 120 can be formed using a typical circuit board manufacturing process such as Additive Process, Subactive Process, MSAP (Modified Semi Additive Process), and SAP (Semi Additive Process), and detailed explanations are omitted here.

The antenna substrate may include a through electrode 130. The through electrode 130 may pass through the insulating layer 110. For example, the through electrode 130 may electrically connect circuit layers disposed on different layers.

The through electrode 130 may include a first through electrode (not shown) passing through the first insulating layer 111, a second through electrode 131 passing through the second insulating layer 112, and a third through electrode 132 passing through the third insulating layer 113.

Meanwhile, a protective layer 140 may be disposed on the insulating layer 110 of a first embodiment. Preferably, when the insulating layer 110 has a plurality of layer structures, the protective layer 140 may be disposed on an insulating layer disposed at an uppermost side or a lowermost side among the plurality of insulating layers. In addition, when the circuit layer 120 has a plurality of layer structures, the protective layer 140 may be disposed on a circuit layer disposed on the insulating layer disposed at the uppermost side or the lowermost side.

The protective layer 140 may be a solder resist.

A planar area of the protective layer 140 of the first embodiment may be equal to or smaller than a planar area of the insulating layer 110. For example, an entire region of the protective layer 140 of the first embodiment may overlap the insulating layer 110 in a thickness direction (z-axis direction). For example, an entire region of the insulating layer 110 of the first embodiment may overlap the protective layer 140 in a thickness direction (z-axis direction).

Accordingly, the protective layer 140 may be divided into a plurality of regions.

The protective layer 140 may include a first region R1 overlapping the circuit layer 120 in a thickness direction (z-axis direction). That is, the protective layer 140 may include a first region R1 in which a lower surface thereof is in direct contact with an upper surface of the circuit layer 120.

In this case, the circuit layer 120 may be disposed on the insulating layer 110 to be spaced apart from each other in a first direction (x-axis direction) or a second direction (y-axis direction). For example, the circuit layer 120 includes a first antenna unit 120-1 and a second antenna unit 120-2 which are disposed to be spaced apart from each other on the insulating layer 110. In this case, planar shapes of the first antenna unit 120-1 and the second antenna unit 120-2 corresponding to the circuit layer 120 are shown to have a rectangular shape, but are not limited thereto. For example, planar shapes of the first antenna unit 120-1 and the second antenna unit 120-2 may have various shapes such as a triangular shape, a circle shape, an elliptical shape, a polygonal shape, a star shape, a fan shape, a cross shape, an X shape, a rhombus shape, a trapezoidal shape and the like.

In addition, the first region R1 of the protective layer 140 may overlap the first antenna unit 120-1 and the second antenna unit 120-2 in the thickness direction (z-axis direction), respectively.

In addition, the protective layer 140 may include a second region R2 which does not overlap the circuit layer 120 in the thickness direction (z-axis direction). That is, the protective layer 140 may include a second region R2 of which a lower surface does not contact the circuit layer 120. For example, the protective layer 140 may include a second region R2 of which a lower surface is in direct contact with an upper surface of the insulating layer 110. For example, the second region R2 of the protective layer 140 may be disposed on an upper surface of the insulating layer 110 of one side region of the first antenna unit 120-1, an upper surface of the insulating layer 110 of the other side region of the second antenna unit 120-2, and an upper surface of the insulating layer 110 of a region between the other side of the first antenna unit 120-1 and one side of the second antenna unit 120-2, respectively. For example, the second region R2 of the protective layer 140 may be disposed on the upper surface of the insulating layer 110 while being in contact with at least one side surface of the first antenna unit 120-1 and the second antenna unit 120-2.

In this case, the protective layer 140 of the first embodiment may have a relatively high permittivity. For example, the protective layer 140 may have a permittivity higher than that of the protective layer 30 of the comparative example. For example, the permittivity Dk of the protective layer 140 may satisfy a range of 20 to 40. Preferably, the permittivity Dk of the protective layer 140 may satisfy a range of 20.5 to 40. More preferably, a permittivity Dk of the protective layer 140 may satisfy a range of 21 to 40.

If the permittivity Dk of the protective layer 140 is less than 20, an effect of reducing a distance between a plurality of antenna units of the embodiment may be insufficient. For example, if the permittivity Dk of the protective layer 140 is less than 20, an effect of reducing a size (e.g., a planar area) of a plurality of antenna units of the embodiment may be insufficient. Specifically, if the permittivity Dk of the protective layer 140 is less than 20, there is a limit to reducing a size of the antenna substrate (thickness in the z-axis direction, width in the x-axis direction, and length in the y-axis direction). In addition, if the permittivity Dk of the protective layer 140 is greater than 40, there may be a problem that the rigidity of the antenna substrate is deteriorated. Also, if the permittivity Dk of the protective layer 140 is greater than 40, there is a problem that a manufacturing cost of the antenna substrate is increased due to the use of the protective layer which is relatively expensive.

That is, the protective layer 140 of the embodiment may have a permittivity higher than that of the protective layer 30 of the comparative example. For example, the permittivity Dk of the protective layer 140 of the embodiment may satisfy a range between 4 and 14 times that of the protective layer 30 of the comparative example. For example, the permittivity Dk of the protective layer 140 of the embodiment may satisfy a range between 4.1 and 14 times that of the protective layer 30 of the comparative example. For example, the permittivity Dk of the protective layer 140 of the embodiment may satisfy a range between 4.2 and 14 times that of the protective layer 30 of the comparative example.

To this end, a content of a filler included in the protective layer 140 of the embodiment may be greater than a content of a filler included in the protective layer 30 of the comparative example.

Specifically, the protective layer 140 of an embodiment may include a resin and a filler dispersed in the resin. The resin applied to the protective layer 140 may have various forms such as a thermosetting resin, a photosensitive resin, and ink.

In addition, the filler disposed in the resin of the protective layer 140 may include a material different from the filler disposed in the resin of the protective layer 30 of the comparative example.

For example, the filler included in the protective layer 30 of the comparative example may include SiO₂.

Alternatively, the protective layer 140 of the embodiment may include a filler including at least one selected from the group consisting of TiO₂, Al₂O₃, BaTiO₃, and CaTiO₃. In this case, the permittivity of TiO₂, Al₂O₃, BaTiO₃, and CaTiO₃ may be greater than that of SiO₂, and the permittivity of the protective layer 140 of the embodiment may be greater than that of the protective layer 30 of the comparative example.

For example, the protective layer 140 of the embodiment may include at least one filler selected from TiO₂, Al₂O₃, BaTiO₃, and CaTiO₃ in the resin, and SiO₂ may be further included therein.

That is, the protective layer 140 of the embodiment may include at least one selected from among TiO₂, Al₂O₃, BaTiO₃, and CaTiO₃. Alternatively, the protective layer 140 of the embodiment may further include SiO2 in at least one selected from among TiO₂, Al₂O₃, BaTiO₃, and CaTiO₃.

In this case, as a result of thermogravimetric analysis (TGA) as shown in FIG. 6 (a), it may be confirmed that 17.48 wt% of a filler is included in the protective layers 30 and SR #1 of the comparative example. Accordingly, the protective layers 30 and SR #1 of the comparative example have a lower permittivity than that of the protective layer of the embodiment.

In addition, the protective layer 30 of the comparative example generally includes fillers with a content of 34.67 wt% or less, and thus has a relatively low permittivity.

Alternatively, as a result of thermogravimetric analysis (TGA) as shown in FIG. 6 (b), it was confirmed that 65.33 wt% of a filler was included in the protective layers 140 and SR #2 of the embodiment. Specifically, in the embodiment, it was confirmed that a content of the filler of the protective layers 140 and SR #2 is higher than that of the protective layers 30 and SR #1 of the comparative example, and thus the permittivity is higher than that of the protective layers 30 and SR #1 of the comparative example.

Furthermore, an embodiment may include a filler having an 82.52 wt% content in the protective layer 140, such that the permittivity of the protective layer 140 is 30 or more.

Accordingly, the protective layer 140 of the embodiment may have a high permittivity compared to the protective layer of the comparative example.

Specifically, the protective layer 140 of the embodiment has a higher permittivity than the protective layer 30 of the comparative example. This may be due to the fact that the protective layer 140 of the embodiment includes a filler selected from TiO₂, Al₂O₃, BaTiO₃, and CaTiO₃ having relatively high permittivity. In addition, this may be due to the fact that the content of the filler included in the protective layer 140 of the embodiment is higher than the content of the filler included in the protective layer 30 of the comparative example.

For example, the protective layer 140 of the embodiment includes a filler in a range of 35 wt% to 85 wt%. Preferably, the protective layer 140 of the embodiment includes a filler in a range of 36 wt% to 84 wt%. More preferably, the protective layer 140 of the embodiment includes a filler in a range of 37 wt% to 83 wt%.

If the content of the filler in the protective layer 140 is less than 35 wt%, there may be a problem that the protective layer 140 does not have a permittivity of a required level. If the content of the filler in the protective layer 140 exceeds 84 wt%, there may be a problem that an unit price of a product increases or the rigidity of the antenna substrate is reduced.

The protective layer 140 of the embodiment may have a permittivity (Dk) in a range of 20 to 40 and a dielectric loss (Df) in a range of 0.015 to 0.05 as the filler selected from TiO₂, Al₂O₃, BaTiO₃, and CaTiO₃ has a content of 35 to 85 wt%.

Meanwhile, an average size of the filler included in the protective layer 140 of an embodiment may be different from an average size of the filler included in the protective layer 30 of the comparative example. For example, an average size of the filler included in the protective layer 30 of the comparative example may be more than 5 µm. Alternatively, an average size of the filler included in the protective layer 140 of an embodiment may be 4 µm or less or 3 µm or less.

As described above, an embodiment includes a protective layer 140 including a filler having a content of 35 wt% to 85 wt%, while including at least one of TiO₂, Al₂O₃, BaTiO₃, and CaTiO₃. Furthermore, the protective layer 140 has a permittivity (Dk) in a range of 20 to 40. Furthermore, the protective layer 140 includes a first region R1 overlapping the circuit layer 120 in a thickness direction (z-axis direction) as shown in the drawing.

Accordingly, a radiation beam radiated from the circuit layer 120 may pass through the first region R1 of the protective layer 140 having a high permittivity. Accordingly, in an embodiment, the radiation beam in the circuit layer 120 passes through the first region R1 of the protective layer 140, so that the resonance frequency band formed by the circuit layer 120 may be shifted to a desired target frequency band.

At this time, in a case of a structure including the protective layer (30, SR#1) of the comparative example, as shown in FIG. 7(a), it was confirmed that a peak frequency of a resonance frequency was formed at 26.3 GHz.

Alternatively, as shown in FIG. 7 (b), in a case of a structure to which the protective layers 140 and SR#2 of the embodiment are applied, it is confirmed that a peak frequency of a resonance frequency is formed at 25.10 GHz. In other words, when the protective layer 140 of the embodiment is applied, it is confirmed that the resonance frequency formed by the circuit layer 120 is shifted downward by about 1200 MHz compared to the resonance frequency formed by the circuit layer of the comparative example.

In addition, the embodiment shifts the resonance frequency as described above, and accordingly a planar area of the circuit layer 120 can be reduced compared to the comparative example.

In other words, the planar area of the circuit layer 120 increases in proportion to the resonant frequency of the circuit layer 120. In this case, in an embodiment, the resonant frequency may be shifted downward by about 1200 MHz compared to the comparative example, and correspondingly, the planar area of the circuit layer 120 may be reduced compared to the comparative example.

Specifically, a width W1 of the circuit layer 120 of the embodiment may be less than a width w1 of the circuit layer 20 of the comparative example. For example, due to the shift of the resonance frequency, a width W1 of the circuit layer 120 of the embodiment may have a range of 50% to 90% of a width w1 of the circuit layer 20 of the comparative example. For example, due to the shift of the resonance frequency, the width W1 of the circuit layer 120 of the embodiment may have a range of 50% to 87% of the width w1 of the circuit layer 20 of the comparative example. For example, due to the shift of the resonance frequency, the width W1 of the circuit layer 120 of the embodiment may have a range of 50% to 85% of the width w1 of the circuit layer 20 of the comparative example.

Accordingly, an embodiment may reduce an area occupied by the circuit layer 120 on the antenna substrate, and thus, a width of the antenna substrate in a horizontal direction may be reduced. Furthermore, an embodiment may increase the number of arrangements of the circuit layers 120 on an antenna substrate having the same area as that of the comparative example. For example, an embodiment may increase the number of circuit layers disposed within the same area as that of the comparative example. For example, an embodiment may improve the degree of integration of the circuit layer 120.

Meanwhile, the first region R1 of the protective layer 140 of an embodiment functions to collect the radiation beams radiated from the circuit layer 120 as described above. For example, the first region R1 of the protective layer 140 of an embodiment functions to shift a resonance frequency by the circuit layer 120.

In addition, the protective layer 140 of the embodiment further includes a second region R2 other than the first region R1.

In this case, the second region R2 is disposed between a plurality of circuit layers. Specifically, the first antenna unit 120-1 and the second antenna unit 120-2 are disposed on the insulating layer 110, which are spaced apart from each other. In addition, the second region R2 of the protective layer 140 is disposed in a region between the first antenna unit 120-1 and the second antenna unit 120-2 on the upper surface of the insulating layer 110. For example, the second region R2 of the protective layer 140 is disposed between the other side surface of the first antenna unit 120-1 adjacent to the second antenna unit 120-2 and one side surface of the second antenna unit 120-2 adjacent to the first antenna unit 120-1.

In this case, the second region R2 of the protective layer 140 has a permittivity Dk in a range of 20 to 40 in a same manner as the first region R1. Accordingly, in an embodiment, since the second region R2 of the protective layer 140 has a high permittivity, a distance D1 between the first antenna unit 120-1 and the second antenna unit 120-2 may be reduced.

For example, the first antenna unit 120-1 and the second antenna unit 120-2 should be spaced apart by a predetermined distance in consideration of signal interference therebetween. In this case, in the comparative example, a plurality of antenna units (e.g., antenna patch) were spaced apart with a distance d1 of 1.7 mm or more. This is because the protective layer having a high permittivity as in the embodiment is not disposed between a plurality of antenna units in the comparative example.

Alternatively, an embodiment may reduce a distance D1 between the first antenna unit 120-1 and the second antenna unit 120-2 as compared with the comparative example by the second region R2 of the protective layer 140.

For example, a distance D1 between the first antenna unit 120-1 and the second antenna unit 120-2 in an embodiment may be 1.5 mm or less. For example, a distance D1 between the first antenna unit 120-1 and the second antenna unit 120-2 in an embodiment may be 1.2 mm or less. For example, a distance D1 between the first antenna unit 120-1 and the second antenna unit 120-2 in an embodiment may be 1.0 mm or less.

For example, the distance D1 between the first antenna unit 120-1 and the second antenna unit 120-2 in the embodiment may be in a range of 0.5 mm to 1.5 mm. Preferably, the distance D1 between the first antenna unit 120-1 and the second antenna unit 120-2 in the embodiment may be in a range of 0.6 mm to 1.5 mm. More preferably, the distance D1 between the first antenna unit 120-1 and the second antenna unit 120-2 in the embodiment may be in a range of 0.8 mm to 1.5 mm.

If the distance D1 between the first antenna unit 120-1 and the second antenna unit 120-2 is less than 0.5 mm, interference between the first antenna unit 120-1 and the second antenna unit 120-2 may occur. For example, if the distance D1 between the first antenna unit 120-1 and the second antenna unit 120-2 is less than 0.5 mm, , the permittivity of the protective layer 140 should be 50 or more in order to solve the interference, and this can cause problems.

When the distance D1 between the first antenna unit 120-1 and the second antenna unit 120-2 is greater than 1.5 mm, the degree of integration of the circuit layer 120 may be reduced. For example, if the distance D1 between the first antenna unit 120-1 and the second antenna unit 120-2 exceeds 1.5 mm, the area in which the circuit layer 120 is disposed may increase, thereby increasing the width of the antenna substrate in the horizontal direction.

Meanwhile, the protective layer 140 of an embodiment may have a predetermined thickness and may be disposed on the insulating layer 110 and the circuit layer 120.

For example, the second region R2 of the protective layer 140 may have a first thickness T1. In this case, the first thickness T1 of the second region R2 may be determined based on a thickness of the circuit layer 120. For example, the first thickness T1 of the second region R2 may be greater than the thickness of the circuit layer 120. In this case, the thickness of the circuit layer 120 may have a range of 10 µm to 25 µm as described above.

Accordingly, the first thickness T1 of the second region R2 of the protective layer 140 may be in a range of 15 µm to 40 µm. For example, the first thickness T1 of the second region R2 of the protective layer 140 may be in a range of 18 µm to 38 µm. For example, the first thickness T1 of the second region R2 of the protective layer 140 may be in a range of 20 µm to 35 µm.

Accordingly, the second thickness T2 of the first region R1 of the protective layer 140 may satisfy a range of 5 µm to 25 µm. For example, the second thickness T2 of the first region R1 of the protective layer 140 may satisfy a range of 8 µm to 23 µm. For example, the second thickness T2 of the first region R2 of the protective layer 140 may satisfy a range of 10 µm to 20 µm.

If the second thickness T2 of the first region R1 of the protective layer 140 is less than 5 µm, the degree of shift of the resonance frequency of the circuit layer 120 due to the first region R1 of the protective layer 140 may be insufficient. If the second thickness T2 of the first region R1 of the protective layer 140 is more than 25 µm, the overall thickness of the antenna substrate may be increased by the thickness of the protective layer 140. Also, if the second thickness T2 of the first region R1 of the protective layer 140 is more than 25 µm, an unit price of a product may be increased.

Meanwhile, although an upper surface of the first region R1 and an upper surface of the second region R2 of the protective layer 140 are disposed on the same plane in the drawing, the embodiment is not limited thereto. For example, the upper surfaces of the first region R1 and the second region R2 of the protective layer 140 may have a step difference. For example, the upper surface of the first region R1 of the protective layer 140 may be positioned higher than the upper surface of the second region R2. For example, the upper surface of the second region R2 of the protective layer 140 may be positioned on the same plane as the upper surface of the circuit layer 120. For example, the upper surface of the second region R2 of the protective layer 140 may be positioned higher than the upper surface of the circuit layer 120, and may be positioned lower than the upper surface of the first region R1 of the protective layer 140. That is, the second region R2 of the protective layer 140 functions to prevent signal interference between a plurality of antenna units of the circuit layer 120. Accordingly, if a height of the second region R2 of the protective layer 140 is not lower than a height of the circuit layer 120, the signal interference preventing function may be normally performed. Accordingly, in an embodiment, a height of the second region R2 of the protective layer 140 is equal to or slightly higher than a height of the circuit layer 120. Accordingly, an embodiment may reduce an arrangement area of the protective layer 140 by a decrease in the height of the second region R2, and accordingly, an unit price of a product may be reduced.

As described above, the antenna substrate of the first embodiment includes an insulating layer, a circuit layer disposed on the insulating layer, and a protective layer. At this time, the protective layer includes a first region that vertically overlaps the circuit layer and a second region that does not vertically overlap the circuit layer. The protective layer has a permittivity in a range of 20 to 40. The first region of the protective layer may shift a resonance frequency of a radiation beam radiated by the circuit layer. In addition, the second region of the protective layer may function to reduce a distance between a plurality of antenna units constituting the circuit layer.

Accordingly, the embodiment may remove an EMC layer included in the antenna substrate of a comparative example, thereby solving problems of the EMC layer.

In addition, in an embodiment, a size (specifically, a planar area) of the circuit layer may be reduced by allowing the resonance frequency to be shifted using the first region of the protective layer. Accordingly, the embodiment may reduce a width of the antenna substrate in a horizontal direction. In addition, the embodiment may integrate the circuit layer included in the antenna substrate. In addition, the embodiment can increase a number of antenna units disposed in a same area compared to the comparative example. In addition, the embodiment may miniaturize an electronic device including an antenna substrate.

In addition, the embodiment may reduce a distance between a plurality of antenna units by using the second region of the protective layer. Specifically, the embodiment can prevent signal interference that may occur between the plurality of antenna units even when the distance between the plurality of antenna units is reduced compared to the comparative example. Accordingly, the embodiment may prevent mutual signal interference of a plurality of antenna units, thereby improving antenna characteristics and performance. In addition, the embodiment may integrate circuit layers included in an antenna substrate. In addition, the embodiment may increase the number of antenna units disposed in a same area as compared to the comparative example.

Meanwhile, in an embodiment, the size and the distance D1 of the first and second antenna units 120-1 and 120-2 of the circuit layer 120 may be reduced by using the first region R1 and the second region R2 of the protective layer 140. Accordingly, in an embodiment, a plurality of antenna units may be disposed in a zigzag pattern on the insulating layer 110.

For example, as shown in FIG. 9, the circuit layer 120 according to an embodiment includes a plurality of antenna units.

In this case, the plurality of antenna units includes a plurality of first groups 120a arranged in a first direction (x-axis direction) on the insulating layer 110. In addition, the plurality of antenna units includes a second group 120b spaced apart from each other in the first direction (x-axis direction) at positions spaced apart from the plurality of first groups 120a in the second direction (y-axis direction) on the insulating layer 110.

In this case, the first group 120a and the second group 120b may be disposed alternately or in a zigzag form.

For example, any one antenna unit included in the first group 120a may be spaced apart from an adjacent antenna unit included in the second group 120b in a diagonal direction (e.g., a direction between the first direction and the second direction).

For example, any one antenna unit included in the second group 120b may be spaced apart from an adjacent antenna unit included in the first group 120a in a diagonal direction (e.g., a direction between the first direction and the second direction).

For example, a specific antenna unit included in the first group 120a may be spaced apart in the second direction in a region between the two antenna units of the second group 120b arranged adjacent to the specific antenna unit.

For example, a specific antenna unit included in the second group 120b may be spaced apart in the second direction in a region between the two antenna units of the first group 120a arranged adjacent to the specific antenna unit of the second group 120b.

For example, the first antenna unit included in the first group 120a may be disposed adjacent to the second antenna unit included in the second group 120b. In this case, the first antenna unit of the first group 120a and the second antenna unit of the second group 120b may be spaced apart from each other in a diagonal direction on the insulating layer 110. For example, the first antenna unit of the first group 120a and the second antenna unit of the second group 120b may be disposed to be spaced apart from each other by a distance D1 in a diagonal direction on the insulating layer 110.

As described above, an embodiment may further improve the degree of integration of the antenna unit as a plurality of antenna units are arranged alternately or in a zigzag shape on the insulating layer. Accordingly, the embodiment may further improve antenna characteristics and performance.

On the other hand, although the antenna units of the first group 120a and the second group 120b are shown in the drawing to have a square shape, the embodiment is not limited thereto, and the shape of the antenna unit may be modified into various shapes.

Hereinafter, an additional embodiment of the antenna substrate will be described.

At this time, a detailed description of the antenna substrate of the additional embodiment having a configuration substantially identical to that of the antenna substrate of the first embodiment will be omitted.

FIG. 10 is a view showing an antenna substrate according to a second embodiment.

Referring to FIG. 10, the antenna substrate includes an insulating layer 210, a circuit layer 220, and a protective layer.

The insulating layer 210 and the circuit layer 220 may be substantially the same as the insulating layer and the circuit layer of the first embodiment. Accordingly, a detailed description of the insulating layer 210 and the circuit layer 220 will be omitted.

The circuit layer 220 may include a first antenna unit 220-1 and a second antenna unit 220-2 spaced apart from each other on the insulating layer 210.

The antenna substrate of the second embodiment may be different from the first embodiment in a structure of a protective layer disposed on the insulating layer 210.

For example, in an antenna substrate of the second embodiment, a plurality of protective layers may be disposed on the insulating layer 210.

For example, the antenna substrate may include a first protective layer 241 formed on the insulating layer 210 and the circuit layer 220. Also, the antenna substrate may include a second protective layer 242 disposed on the first protective layer 241. In this case, the second protective layer 242 may be partially disposed on the first protective layer 241.

The first protective layer 241 may be disposed to cover both surfaces of the insulating layer 210 and the circuit layer 220.

For example, the circuit layer 220 may include a plurality of antenna units 220-1 and 220-2 spaced apart from each other. In addition, the first protective layer 241 may be disposed to cover both upper surfaces of the plurality of antenna units and upper surfaces of the insulating layer spaced apart from each other.

Also, the second protective layer 242 may be disposed on the first protective layer 241 or the circuit layer 220 at a predetermined distance. That is, the first protective layer 241 is formed at a region overlapping the circuit layer 220 in a vertical direction. In this case, the circuit layer 220 includes a plurality of antenna units, which are spaced apart from each other, on the insulating layer 210. Accordingly, the second protective layer 242 can be formed in a certain pattern at a certain distance on the first protective layer 241 or the circuit layer 220 to correspond to the circuit layer 220.

The first protective layer 241 and the second protective layer 242 may have different areas. For example, an area of the first protective layer 241 may be larger than an area of the second protective layer 242. Accordingly, the second protective layer 242 may not be formed on at least a part of an upper surface of the first protective layer 241. For example, the second protective layer 242 may be selectively disposed only at a region of the upper surface of the first protective layer 241, which overlaps the circuit layer 220 in a vertical direction.

A width W2 of the second protective layer 242 may be greater than a width W1 of the circuit layer 220. Accordingly, the second protective layer 242 may include a first portion overlapping the circuit layer 220 in a vertical direction and a second portion other than the first portion that does not overlap with the circuit layer 220. However, an embodiment is not limited thereto, and the second protective layer 242 may overlap the entire region with the circuit layer 220 in the vertical direction while having the same width as the width of the circuit layer 220.

The first protective layer 241 may be formed on the insulating layer 210 with a first thickness T1a. Also, the second protective layer 242 may be formed on the first protective layer 241 with a second thickness T2a. For example, the second thickness T2a of the second protective layer 242 may satisfy a range of 5 µm to 25 µm. For example, the second thickness T2a of the second protective layer 242 may satisfy a range of 8 µm to 23 µm. For example, the second thickness T2a of the second protective layer 242 may satisfy a range of 10 µm to 20 µm. If the second thickness T2a of the second protective layer 242 is less than 5 µm, the degree of shift of the resonance frequency of the circuit layer 220 by the second protective layer 242 may be insufficient. If the second thickness T2a of the second protective layer 242 exceeds 25 µm, an overall thickness of the antenna substrate may be increased by the thickness of the second protective layer 242. Also, if the second thickness T2a of the second protective layer 242 exceeds 25 µm, an unit price of the product may be increased.

To this end, the first thickness T1a of the first protective layer 241 may be greater than the thickness of the circuit layer 220. For example, the first protective layer 241 may have a first thickness T1a of 10.2 µm to 28 µm. Preferably, the first protective layer 241 may have a first thickness T1a of 12.2 µm to 26 µm. More preferably, the first protective layer 241 may have a first thickness T1a of 15.2 µm to 23 µm.

The first thickness T1a of the first protective layer 241 may be a thickness from an upper surface of the insulating layer 210 to an upper surface of the first protective layer 241. More specifically, the first thickness T1a of the first protective layer 241 may be a thickness of a thickest portion of an entire region of the first protective layer 241. Likewise, the second thickness T2a of the second protective layer 242 may be a thickness of a thickest portion of an entire region of the second protective layer 242.

In addition, a first thickness T1a of the first protective layer 241 is greater than a thickness of the circuit layer 220, and accordingly, the first protective layer 241 may be disposed on the circuit layer 220 with a predetermined thickness.

For example, the first protective layer 241 may be formed between the second protective layer 242 and the circuit layer 220. That is, the first protective layer 241 may be disposed to have a predetermined thickness between the circuit layer 220 and the second protective layer 242.

A third thickness T3a of the first protective layer 241 between the circuit layer 220 and the second protective layer 242 may be in a range of 0.2 µm to 3 µm. If the third thickness T3a is greater than 3 µm, a frequency shift effect by the second protective layer 242 may be insufficient. Also, if the third thickness T3a is greater than 3 µm, an entire thickness of the antenna substrate may be increased due to an increase in a thickness of the first protective layer 241.

Meanwhile, the thickness of the first protective layer 241 means a thickness from a lower surface of the circuit layer 220 to an upper surface of the first protective layer 241. A thickness of the first protective layer 241 may include a thickness of the circuit layer 220 and a thickness of the first protective layer 241 on the circuit layer 220.

In addition, unlike in FIG. 10, a portion of the first protective layer 241 formed between the circuit layers 220 may be located lower than the circuit layer 220. For example, the first protective layer 241 in a modified example of FIG. 10 may include a first region disposed on the circuit layer 220 and a second region disposed on the insulating layer 210 between the circuit layers 220. In addition, a thickness of the first protective layer 241 may be a sum of a thickness of the circuit layer 220 and a thickness of the first region of the first protective layer 241. In addition, the thickness of the second region of the first protective layer 241 may be thinner than that of the circuit layer 220.

Meanwhile, the first protective layer 241 and the second protective layer 242 may have different permittivity. Specifically, a permittivity of the second protective layer 242 may be greater than that of the first protective layer 241.

Preferably, the first protective layer 241 may correspond to the protective layer 30 described in the comparative example. For example, the first protective layer 241 may have a permittivity Dk of 3 to 5.

In addition, the second protective layer 242 may have a higher permittivity than the first protective layer 241. Specifically, the second protective layer 242 may correspond to the protective layer 140 described in the first embodiment.

According to the second embodiment, the antenna substrate includes a first protective layer and a second protective layer. In addition, the first protective layer may be disposed in a region that does not vertically overlap the circuit layer on the antenna substrate. In addition, the second protective layer may be disposed in a region vertically overlapping the circuit layer. According to the second embodiment, the embodiment may efficiently shift a resonance frequency of the circuit layer while minimizing an arrangement area of the second protective layer.

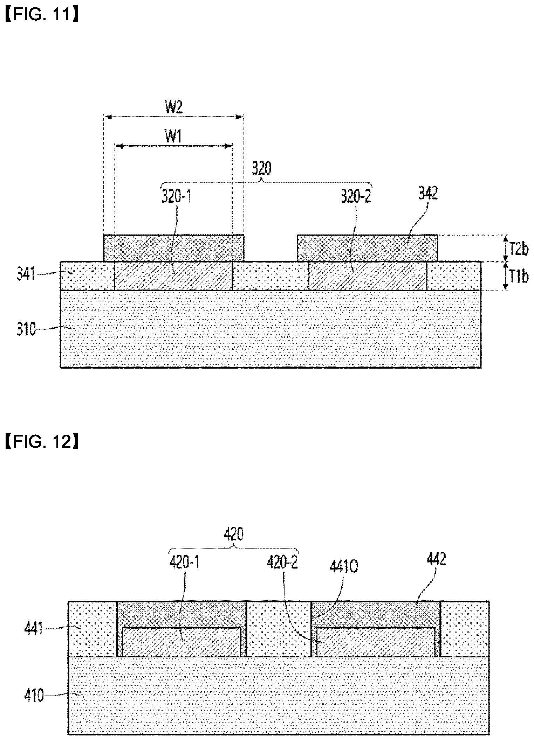

FIG. 11 is a view showing an antenna substrate according to a third embodiment.

Referring to FIG. 11, the antenna substrate includes an insulating layer 310, a circuit layer 320, and a protective layer.

The insulating layer 310 and the circuit layer 320 may be substantially the same as the insulating layer and the circuit layer of the second embodiment. Accordingly, a detailed description of the insulating layer 310 and the circuit layer 320 will be omitted.

The circuit layer 320 may include a first antenna unit 320-1 and a second antenna unit 320-2 spaced apart from each other on the insulating layer 310.

In the antenna substrate of the third embodiment, a plurality of protective layers may be disposed on the insulating layer 310.

For example, the antenna substrate may include a first protective layer 341 formed on the insulating layer 310 and the circuit layer 320. Also, the antenna substrate may include a second protective layer 342 disposed on the first protective layer 341. In this case, the second protective layer 342 may be partially disposed on the first protective layer 341.

The first protective layer 341 may be disposed to cover an entire surface of the insulating layer 310. For example, the circuit layer 320 may include a plurality of antenna units 320-1 and 320-2 spaced apart from each other. In addition, the first protective layer 341 may be disposed on an upper surface of the insulating layer in a region between a plurality of antenna units spaced apart from each other.

Furthermore, the second protective layer 342 may be disposed on the first protective layer 341 or the circuit layer 320 at a predetermined distance. That is, the first protective layer 341 is formed in a region overlapping the circuit layer 320 in a vertical direction. In this case, the circuit layer 320 includes a plurality of antenna units, which are spaced apart from each other, on the insulating layer 310. Accordingly, the second protective layer 342 can be formed in a certain pattern at a certain distance on the first protective layer 341 or the circuit layer 320 to correspond to the circuit layer 320.

The second protective layer 342 may be selectively disposed in a region of an upper surface of the first protective layer 341, which overlaps the circuit layer 320 in a vertical direction. Also, the second protective layer 342 may be selectively disposed on an upper surface of the first protective layer 341.

A width W2 of the second protective layer 342 may be greater than a width W1 of the circuit layer 320. Accordingly, the second protective layer 342 may include a first portion in direct contact with an upper surface of the circuit layer 320 and a second portion in direct contact with an upper surface of the first protective layer 341.

The first protective layer 341 may be formed on the insulating layer 310 with a first thickness T1b. Also, the second protective layer 342 may be formed on the first protective layer 341 with a second thickness T2b. For example, the second thickness T2b of the second protective layer 342 may satisfy a range of 5 µm to 25 µm. For example, the second thickness T2b of the second protective layer 342 may satisfy a range of 8 µm to 23 µm. For example, the second thickness T2b of the second protective layer 342 may satisfy a range of 10 µm to 20 µm.

To this end, the first thickness T1b of the first protective layer 341 may be the same as the thickness of the circuit layer 320. For example, the first protective layer 341 may have a first thickness T1b of 10 µm to 25 µm. Preferably, the first protective layer 341 may have a first thickness T1b of 12 µm to 23 µm. More preferably, the first protective layer 341 may have a first thickness T1b of 15 µm to 20 µm.

However, an embodiment is not limited thereto. For example, a thickness of the first protective layer 341 may be less than a thickness of the circuit layer 320. Accordingly, an upper surface of the first protective layer 341 and an upper surface of the circuit layer 320 may have a step difference. In addition, the second protective layer 342 may be disposed on a portion of an upper surface of the first protective layer 341 having the step difference and on the upper surface of the circuit layer 320. Accordingly, a lower surface of the second protective layer 342 may have a step difference.

FIG. 12 is a view showing an antenna substrate according to a fourth embodiment.

Referring to FIG. 12, the antenna substrate includes an insulating layer 410, a circuit layer 420, and a protective layer.

The insulating layer 410 and the circuit layer 420 may be substantially the same as the insulating layer and the circuit layer of the third embodiment. Accordingly, a detailed description of the insulating layer 410 and the circuit layer 420 will be omitted.

The circuit layer 420 may include a first antenna unit 420-1 and a second antenna unit 420-2 spaced apart from each other on the insulating layer 410.

In the antenna substrate of the fourth embodiment, a plurality of protective layers may be disposed on the insulating layer 410.

For example, the antenna substrate may include a first protective layer 441 disposed on the insulating layer 410. Also, the antenna substrate may include a second protective layer 442 disposed on the insulating layer 410 and the circuit layer 420.

The first protective layer 441 may have the same material or permittivity as the first protective layer of the second and third embodiments. In addition, the second protective layer 442 may have the same material or permittivity as the second protective layer of the second and third embodiments.

In this case, the second protective layers of the second and third embodiments are disposed only in the region vertically overlapping the circuit layer. For example, the second protective layers of the second and third embodiments are not disposed in a region horizontally overlapping the circuit layer. Accordingly, the antenna substrates of the second and third embodiments had only the shift characteristic of the resonance frequency.

Alternatively, the second protective layer of the fourth embodiment may be formed not only in a region vertically overlapping with the circuit layer 420 but also in a region horizontally overlapping.

Specifically, the first protective layer 441 may include an opening 441O. For example, the first protective layer 441 is disposed on the insulating layer 410. In this case, the first protective layer 441 may not vertically overlap the circuit layer 420. Preferably, the first protective layer 441 may include an opening 441O vertically overlapping the circuit layer 420.

In this case, a width of the opening 441O may be greater than a width of the circuit layer 420.

Accordingly, the opening 441O of the first protective layer 441 includes a first portion vertically overlapping the circuit layer 420. Also, the opening 441O of the first protective layer 441 includes a second portion vertically overlapping an upper surface of the insulating layer 410 adjacent to the circuit layer 420.

In addition, the second protective layer 442 may be disposed in the opening 441O of the first protective layer 441.

Specifically, the second protective layer 442 may be disposed in the opening 441O of the first protective layer 441 to surround the circuit layer 420.

The second protective layer 442 may be disposed to cover an upper surface and a side surface of the circuit layer 420.

Accordingly, the second protective layer 442 of the fourth embodiment is disposed not only in a region vertically overlapping the circuit layer 420 but also in a region horizontally overlapping the circuit layer 420.

Therefore, the second protective layer 442 of the antenna substrate of the fourth embodiment may perform not only a shift function of the resonance frequency of the circuit layer 420 but also a signal interference prevention function of reducing a distance between a plurality of antenna units.

Furthermore, the fourth embodiment may perform both the resonance frequency shift function and the signal interference prevention function while minimizing an arrangement area of the second protective layer 442, which is relatively expensive compared to the first embodiment.

Meanwhile, in the drawing, the first protective layer 441 is shown to have the same height or thickness as the second protective layer 442, but is not limited thereto.

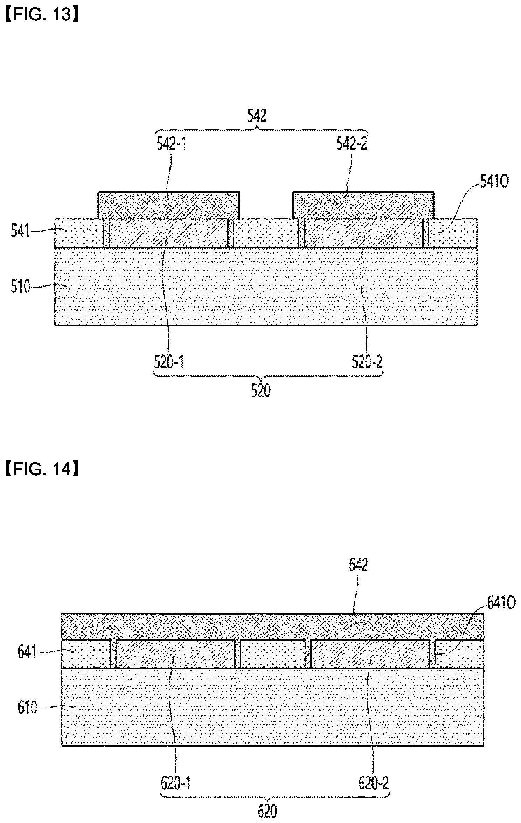

FIG. 13 is a view showing an antenna substrate according to a fifth embodiment.

Referring to FIG. 13, the antenna substrate includes an insulating layer 510, a circuit layer 520, and a protective layer.

The insulating layer 510 and the circuit layer 520 may be substantially the same as the insulating layer and the circuit layer of the fourth embodiment. Accordingly, a detailed description of the insulating layer 510 and the circuit layer 520 will be omitted.

The circuit layer 520 may include a first antenna unit 520-1 and a second antenna unit 520-2 spaced apart from each other on the insulating layer 510.

In the antenna substrate of the fifth embodiment, a plurality of protective layers may be disposed on the insulating layer 510. For example, the antenna substrate may include a first protective layer 541 disposed on the insulating layer 510. Also, the antenna substrate may include a second protective layer 542 disposed on the insulating layer 510 and the circuit layer 520.

The first protective layer 541 may have the same material or permittivity as the first protective layer of the fourth embodiment. In addition, the second protective layer 542 may have the same material or permittivity as the second protective layer of the fourth embodiment.

The first protective layer 541 may include an opening 541O. For example, the first protective layer 541 is disposed on the insulating layer 510. In this case, the first protective layer 541 may not vertically overlap the circuit layer 520. Preferably, the first protective layer 541 may include an opening 541O vertically overlapping the circuit layer 520.

In this case, a width of the opening 541O may be greater than a width of the circuit layer 520. Accordingly, the opening 541O of the first protective layer 541 includes a first portion vertically overlapping the circuit layer 520. Also, the opening 541O of the first protective layer 541 includes a second portion vertically overlapping an upper surface of the insulating layer 510 adjacent to the circuit layer 520.

In addition, the second protective layer 542 may be disposed in the opening 541O of the first protective layer 541. Specifically, the second protective layer 542 may be disposed in the opening 541O of the first protective layer 541 to surround the circuit layer 520.

The second protective layer 542 may be disposed to cover an upper surface and a side surface of the circuit layer 520.

Accordingly, the second protective layer 542 of the fifth embodiment is disposed not only in a region vertically overlapping the circuit layer 520 but also in a region horizontally overlapping the circuit layer 520.

In this case, a height or thickness of the first protective layer 541 may be less than or equal to a height or thickness of the circuit layer 520.

In addition, the upper surface of the second protective layer 542 is disposed on the upper surface of the circuit layer 520, and thus may be positioned higher than the upper surface of the first protective layer 541.

Accordingly, the second protective layer 542 may include a first portion disposed to surround the circuit layer 520 within the opening 541O and a second portion extending from the first portion. In addition, the second portion of the second protective layer 542 may be disposed on an upper surface of the first protective layer 541 having a relatively low height.

However, the embodiment is not limited thereto. For example, the second protective layer 542 may be disposed only in a region vertically overlapping the opening 541O and the circuit layer 520 while having a height higher than that of the upper surface of the first protective layer 541. In addition, the second protective layer 542 of the fifth embodiment may be disposed on each of the plurality of antenna units in a pattern shape.

FIG. 14 is a view showing an antenna substrate according to a sixth embodiment.

Referring to FIG. 14, the antenna substrate includes an insulating layer 610, a circuit layer 620, and a protective layer.

The insulating layer 610 and the circuit layer 620 may be substantially the same as the insulating layer and the circuit layer of the fifth embodiment. Accordingly, a detailed description of the insulating layer 610 and the circuit layer 620 will be omitted.

The circuit layer 620 may include a first antenna unit 620-1 and a second antenna unit 620-2 spaced apart from each other on the insulating layer 610.

In the antenna substrate of the sixth embodiment, a plurality of protective layers may be disposed on the insulating layer 610. For example, the antenna substrate may include a first protective layer 641 disposed on the insulating layer 610. Also, the antenna substrate may include a second protective layer 642 disposed on the insulating layer 610 and the circuit layer 620.

In this case, a plurality of second protective layers 542 of the fifth embodiment are disposed on the circuit layer 520 in a pattern shape.

Alternatively, the second protective layer 642 of the sixth embodiment may be integrally formed. For example, the second protective layer 642 of the sixth embodiment may be entirely disposed on the first protective layer 641, the opening 641O of the first protective layer 641, and a plurality of antenna units of the circuit layer 620. For example, the second protective layer (642) of the sixth embodiment may be formed as an integral part that is interconnected rather than in a pattern shape on multiple antenna units.

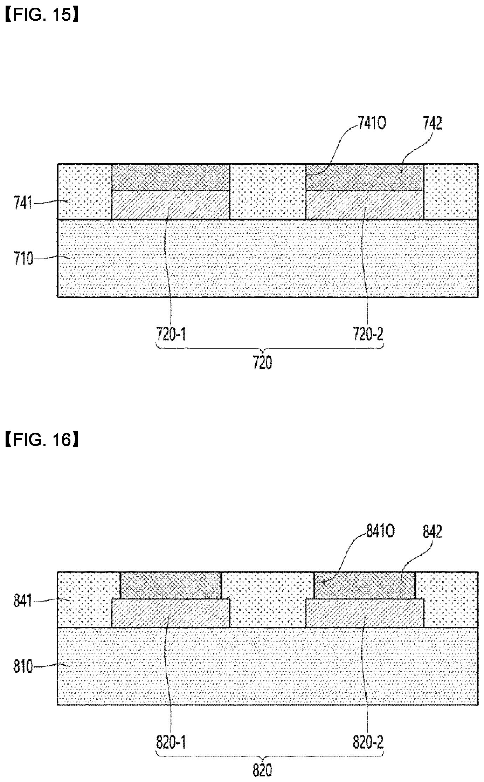

FIG. 15 is a view showing an antenna substrate according to a seventh embodiment.

Referring to FIG. 15, the antenna substrate includes an insulating layer 710, a circuit layer 720, and a protective layer.

The insulating layer 710 and the circuit layer 720 may be substantially the same as the insulating layer and the circuit layer of the fourth to sixth embodiments. Accordingly, a detailed description of the insulating layer 710 and the circuit layer 720 will be omitted.

The circuit layer 720 may include a first antenna unit 720-1 and a second antenna unit 720-2 that are spaced apart from each other on the insulating layer 710.

In the antenna substrate of the seventh embodiment, a plurality of protective layers may be disposed on the insulating layer 710. For example, the antenna substrate may include a first protective layer 741 disposed on the insulating layer 710. Also, the antenna substrate may include a second protective layer 742 disposed on the circuit layer 720.

In this case, the antenna substrate of the seventh embodiment may be different from the antenna substrate of the fourth embodiment in a width of an opening of the first protective layer and an arrangement structure of the second protective layer accordingly.

For example, the opening of the first protective layer of the fourth embodiment had a width greater than that of the circuit layer.

Alternatively, the opening 7410 of the first protective layer 741 of the seventh embodiment may have the same width as that of the circuit layer 720.

Accordingly, the second protective layer 742 may be disposed only on an upper surface of the circuit layer 720 within the opening 7410 of the first protective layer 741.

FIG. 15 is a view showing an antenna substrate according to a eighth embodiment.

Referring to FIG. 16, the antenna substrate includes an insulating layer 810, a circuit layer 820, and a protective layer.

The insulating layer 810 and the circuit layer 820 may be substantially the same as the insulating layer and the circuit layer of the seventh embodiment. Accordingly, a detailed description of the insulating layer 810 and the circuit layer 820 will be omitted.

The circuit layer 820 may include a first antenna unit 820-1 and a second antenna unit 820-2 spaced apart from each other on the insulating layer 810.

In the antenna substrate of the eighth embodiment, a plurality of protective layers may be disposed on the insulating layer 810. For example, the antenna substrate may include a first protective layer 841 disposed on the insulating layer 810. Also, the antenna substrate may include a second protective layer 842 disposed on the circuit layer 820.

In this case, the antenna substrate of the eighth embodiment may be different from the antenna substrate of the fourth and seventh embodiments in a width of an opening of the first protective layer and an arrangement structure of the second protective layer accordingly.

For example, the opening of the first protective layer of the fourth embodiment has a width greater than that of the circuit layer. In addition, the opening of the first protective layer of the seventh embodiment has the same width as the width of the circuit layer.

Alternatively, the opening 8410 of the first protective layer 841 of the eighth embodiment may have a width smaller than that of the circuit layer 820.

Accordingly, the second protective layer 842 may be partially disposed on the upper surface of the circuit layer 820.

For example, the first protective layer 841 may be disposed on the insulating layer 810 to cover at least a portion of the upper surface of the circuit layer 820. For example, an edge region of the upper surface of the circuit layer 820 may be covered with the first protective layer 841. In addition, the second protective layer 842 may be disposed to cover a central region of the upper surface of the circuit layer 820 in the opening 8410 of the first protective layer 841.

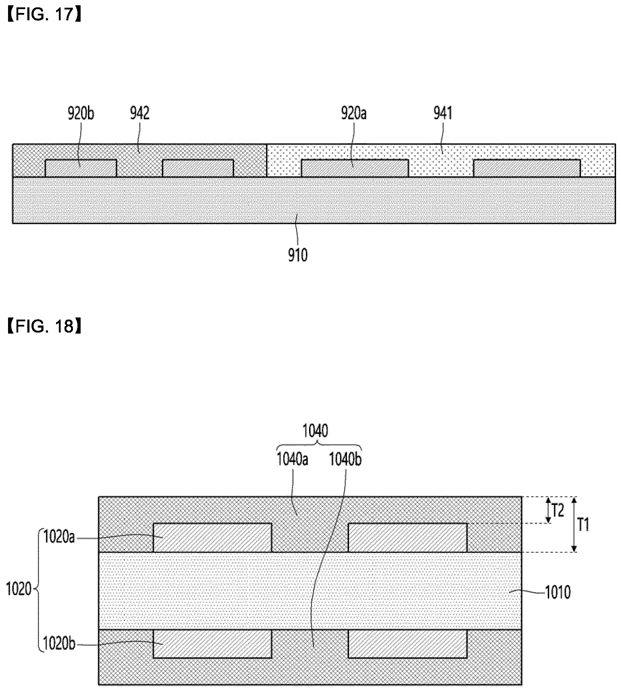

FIG. 17 is a view showing an antenna substrate according to a ninth embodiment.

Referring to FIG. 17, the antenna substrate includes an insulating layer 910, a circuit layer, and a protective layer.

An upper surface of the insulating layer 910 may be divided into a plurality of regions. For example, an upper surface of the insulating layer 910 may include a first antenna region and a second antenna region.

In addition, a first circuit layer 920a including a plurality of antenna units may be disposed in the first antenna region on the upper surface of the insulating layer 910.

Also, a second circuit layer 920b including a plurality of antenna units may be disposed in the second antenna region of the insulating layer 910.

In this case, the first circuit layer 920a and the second circuit layer 920b may be classified according to antenna characteristics. For example, the first circuit layer 920a may include an antenna unit requiring relatively low integration. And, the second circuit layer 920b may include an antenna unit requiring relatively high integration.

Accordingly, in the embodiment, a plurality of protective layers are disposed on the insulating layer 910 according to required characteristics of the antenna unit of each circuit layer.

For example, in an embodiment, a first protective layer 941 may be disposed to cover the first circuit layer 920a on the first antenna region of the insulating layer 910. The first protective layer 941 may correspond to a first protective layer having a relatively low permittivity described in the previous embodiment.

And, in an embodiment, a second protective layer 942 may be disposed on the second antenna region of the insulating layer 910 to cover the second circuit layer 920b. The second protective layer 942 may correspond to the second protective layer having a relatively high permittivity described in the previous embodiment.

In the ninth embodiment, the upper region of the insulating layer is divided into a plurality of antenna regions according to the required characteristics of the antenna unit. In addition, a circuit layer including a plurality of antenna units is disposed in the antenna region. In addition, a protective layer having different permittivity is disposed on the plurality of antenna regions while covering each antenna unit. Accordingly, the embodiment may provide an antenna substrate that efficiently satisfies the required characteristics of the antenna unit while minimizing the arrangement area of the second protective layer having a relatively high permittivity.

FIG. 18 is a view showing an antenna substrate according to a tenth embodiment.

Referring to FIG. 18, the antenna substrate includes an insulating layer 1010, a circuit layer 1020, and a protective layer 1040.

The circuit layer 1020 may be disposed on both surfaces of the insulating layer 1010, respectively.

For example, the circuit layer may include an upper circuit layer 1020a disposed on an upper surface of the insulating layer 1010 and a lower circuit layer 1020b disposed on a lower surface of the insulating layer 1010.

That is, the antenna substrate of the tenth embodiment may be a doublesided antenna substrate that radiates radiation beams from upper and lower portions of the insulating layer 1010, respectively.

For example, the upper circuit layer 1020a may radiate a first radiation beam to the upper region of the insulating layer 1010. For example, the lower circuit layer 1020b may radiate a second radiation beam different from the first radiation beam to the lower region of the insulating layer 1010.

In addition, the protective layer 1040 may include a first high permittivity protective layer 1040a disposed to cover the upper circuit layer 1020a on the upper surface of the insulating layer 1010.

In addition, the protective layer 1040 may include a second high permittivity protective layer 1040b disposed to cover the lower circuit layer 1020b on the lower surface of the insulating layer 1010.

The first high permittivity protective layer 1040a and the second high permittivity protective layer 1040b may correspond to the protective layer 140 or the second protective layer described in the previous embodiment. For example, the first high permittivity protective layer 1040a and the second high permittivity protective layer 1040b may have a permittivity Dk in a range of 20 to 40.

Meanwhile, the antenna substrates of the first to tenth embodiments have been described above. In this case, the antenna substrate of the present invention may have a structure in which at least two of the structures of the first to tenth embodiments are mixed. As an example, an arrangement structure of the second protective layer disposed in the second antenna region of FIG. 17 may have any one structure of the protective layer disposed on the antenna substrate of the first to eighth embodiments.

Hereinafter, an antenna device according to an embodiment will be described.

The antenna device of an embodiment may include any one of the antenna substrates illustrated in FIGS. 5, 11 to 18. Hereinafter, it will be described that the antenna substrate applied to the antenna device of the embodiment includes the antenna substrate according to the first embodiment of FIG. 5. However, the antenna device of the embodiment is not limited thereto, and may include an antenna substrate of other embodiments other than the first embodiment.

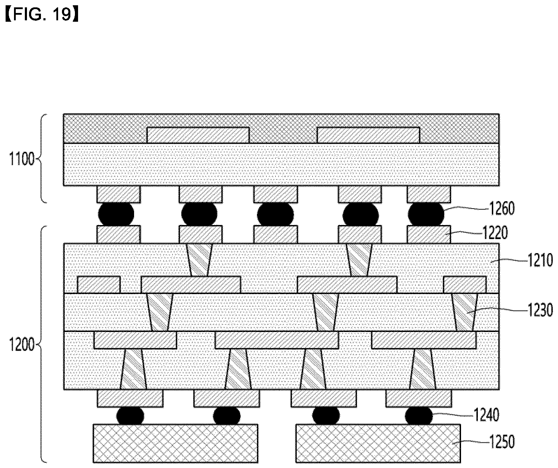

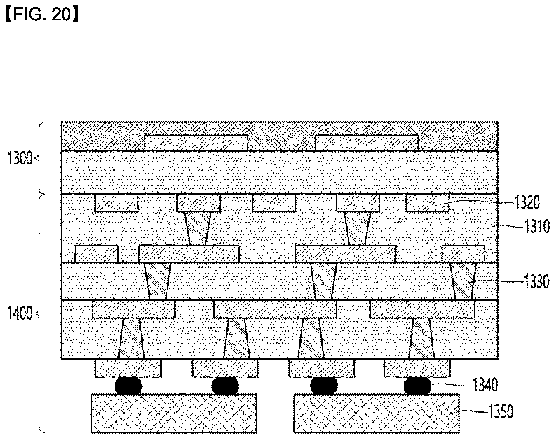

FIG. 19 is a view showing an antenna device according to a first embodiment, and FIG. 20 is a view showing an antenna device according to a second embodiment.

Referring to FIG. 19, an antenna device according to a first embodiment may include an antenna substrate 1100 and a driving substrate 1200.

The antenna substrate 1100 may correspond to any one of the first to tenth embodiments of the present invention.

The driving substrate 1200 may be manufactured separately from the antenna substrate 1100. For example, the driving substrate 1200 may be a substrate separated from the antenna substrate 1100.

In addition, the antenna device of the first embodiment may manufacture the separated antenna substrate 1100 and driving substrate 1200 through separate processes, respectively, and accordingly, may proceed with a process of combining them.

The driving substrate 1200 may include a plurality of insulating layers 1210. For example, the driving substrate 1200 may include three insulating layers, but is not limited thereto. That is, the driving substrate 1200 may include two or less insulating layers, and alternatively, may include four or more insulating layers.

The driving substrate 1200 may include a circuit pattern layer 1220 formed on a surface of at least one insulating layer 1210.

The driving substrate 1200 may include a through electrode 1230 passing through at least one insulating layer 1210. The through electrode 1230 of the driving substrate 1200 may electrically connect the circuit pattern layers 1220 disposed on different layers.

The driving substrate 1200 may include a first connection part 1240 disposed on a lowermost circuit pattern layer among the circuit pattern layers 1220. The first connection part 1240 may be a solder ball, but is not limited thereto.

The driving substrate 1200 may include an element attached to the first connection part 1240. In this case, the driving substrate 1200 includes a plurality of first connection parts spaced apart from each other. In addition, the driving substrate 1200 may include a plurality of elements mounted on the plurality of first connection parts, respectively.

For example, the driving substrate 1200 may include a driving element mounted on at least one first connection part among a plurality of first connection parts. The driving element may be a driving element for driving antenna units of circuit layers included in the antenna substrate 1100. For example, the driving element transmits a transmission signal to the antenna substrate 1100, so that a wireless signal corresponding to the transmission signal may be transmitted to an outside. Further, the driving element may receive a reception signal received through the antenna substrate 1100, analyze the received signal, and obtain reception information.

Also, the driving substrate 1200 may include a passive element mounted on at least one of the plurality of first connection portions. The passive element may be an element for supporting or assisting an operation of the driving element. For example, the passive element may include a resistor, a capacitor, an inductor, and the like.

Meanwhile, the antenna device may include a second connection part 1260 disposed between the driving substrate 1200 and the antenna substrate 1100. The second connection part 1260 may be a solder ball, but is not limited thereto.

Meanwhile, although not shown in the drawing, the antenna device may further include a molding layer disposed between the antenna substrate 1100 and the driving substrate 1200 and molding the second connection part 1260.

Meanwhile, as shown in FIG. 20, the antenna device according to the second embodiment includes a first substrate layer 1300 and a second substrate layer 1400.

In this case, the first substrate layer 1300 and the second substrate layer 1400 may constitute a single substrate.

For example, the antenna device of the second embodiment can first manufacture the first substrate layer 1300 corresponding to the antenna substrate. Thereafter, the embodiment can perform a process of forming an insulating layer 1310, a circuit pattern layer 1320, a through electrode 1330, a first connection portion 1340, and an element 1350 corresponding to the second substrate layer 1400 on the first substrate layer 1300, thereby manufacturing an antenna device composed of a single substrate. Compared to the first embodiment, the antenna device of the second embodiment can omit the second connection portion, and the antenna substrate and the driving substrate can be provided as a single integrated substrate.

An antenna substrate of an embodiment includes an insulating layer, a circuit layer disposed on the insulating layer, and a protective layer. At this time, the protective layer includes a first region that vertically overlaps the circuit layer and a second region that does not vertically overlap the circuit layer. The protective layer has a permittivity in a range of 20 to 40. The first region of the protective layer may shift a resonance frequency of a radiation beam radiated by the circuit layer. In addition, the second region of the protective layer may function to reduce a distance between a plurality of antenna units constituting the circuit layer.

Accordingly, the embodiment may remove an EMC layer included in the antenna substrate of a comparative example, thereby solving problems of the EMC layer.

In addition, in an embodiment, a size (specifically, a planar area) of the circuit layer may be reduced by allowing the resonance frequency to be shifted using the first region of the protective layer. Accordingly, the embodiment may reduce a width of the antenna substrate in a horizontal direction. In addition, the embodiment may integrate the circuit layer included in the antenna substrate. In addition, the embodiment can increase a number of antenna units disposed in a same area compared to the comparative example. In addition, the embodiment may miniaturize an electronic device including an antenna substrate.

In addition, the embodiment may reduce a distance between a plurality of antenna units by using the second region of the protective layer. Specifically, the embodiment can prevent signal interference that may occur between the plurality of antenna units even when the distance between the plurality of antenna units is reduced compared to the comparative example. Accordingly, the embodiment may prevent mutual signal interference of a plurality of antenna units, thereby improving antenna characteristics and performance. In addition, the embodiment may integrate circuit layers included in an antenna substrate. In addition, the embodiment may increase the number of antenna units disposed in a same area as compared to the comparative example.

Meanwhile, the circuit layer of the embodiment includes a plurality of antenna units disposed on the insulating layer. In this case, the embodiment uses the first region and the second region of the protective layer to allow the plurality of antenna units to be disposed alternately or in a zigzag pattern on the insulating layer. That is, the embodiment can further improve the integration of the antenna units by arranging a plurality of antenna units alternately or zigzag on the insulating layer. Accordingly, the embodiment can further improve the antenna characteristics and performance.

Meanwhile, the protective layer of the embodiment includes a first protective layer and a second protective layer. The first protective layer is a protective layer having a relatively low permittivity. In addition, the second protective layer is a protective layer having a relatively high permittivity.

In addition, the second protective layer may be disposed in a region vertically overlapping the circuit layer. In addition, the first protective layer may be selectively disposed in a region where the second protective layer is not disposed. Accordingly, the embodiment may maximize antenna characteristics and performance while minimizing an arrangement area of the second protective layer.

Meanwhile, the antenna device of an embodiment may be applied to an electronic device. In this case, the electronic device may be a smart phone, a personal digital assistant, a digital video camera, a digital still camera, a vehicle, a highperformance server, a network system, computer, monitor, tablet, laptop, netbook, television, video game, smart watch, automotive, or the like. However, the embodiment is not limited thereto, and may be any other electronic device that processes data in addition to these.

On the other hand, when the circuit board having the above-described characteristics of the invention is used in an IT device or home appliance such as a smart phone, a server computer, a TV, and the like, functions such as signal transmission or power supply can be stably performed. For example, when the circuit board having the features of the present invention performs a semiconductor package function, it can function to safely protect the semiconductor chip from external moisture or contaminants, or alternatively, it is possible to solve problems of leakage current, electrical short circuit between terminals, and electrical opening of terminals supplied to the semiconductor chip. In addition, when the function of signal transmission is in charge, it is possible to solve the noise problem. Through this, the circuit board having the above-described characteristics of the invention can maintain the stable function of the IT device or home appliance, so that the entire product and the circuit board to which the present invention is applied can achieve functional unity or technical interlocking with each other.

When the circuit board having the characteristics of the invention described above is used in a transport device such as a vehicle, it is possible to solve the problem of distortion of a signal transmitted to the transport device, or alternatively, the safety of the transport device can be further improved by safely protecting the semiconductor chip that controls the transport device from the outside and solving the problem of leakage current or electrical short between terminals or the electrical opening of the terminal supplied to the semiconductor chip. Accordingly, the transportation device and the circuit board to which the present invention is applied can achieve functional integrity or technical interlocking with each other.

The characteristics, structures and effects described in the embodiments above are included in at least one embodiment but are not limited to one embodiment. Furthermore, the characteristics, structures, and effects and the like illustrated in each of the embodiments may be combined or modified even with respect to other embodiments by those of ordinary skill in the art to which the embodiments pertain. Thus, it should be construed that contents related to such a combination and such a modification are included in the scope of the embodiment.

## Claims

1. An antenna substrate comprising:
an insulating layer;
a circuit layer disposed on the insulating layer; and
a protective layer disposed on the insulating layer and the circuit layer,
wherein the protective layer is disposed to overlap with the circuit layer in a vertical direction and a horizontal direction, and has a permittivity (Dk) of between 20 and 40.

2. The antenna substrate of claim 1, wherein the circuit layer is an antenna unit disposed on an uppermost side of the antenna substrate, and
wherein the protective layer is a solder resist disposed on the insulating layer and the antenna unit.

3. The antenna substrate of claim 1 or 2, wherein the protective layer includes:
a resin; and
a filler disposed in the resin and composed of at least one of TiO₂, Al₂O₃, BaTiO₃, and CaTiO₃.

4. The antenna substrate of claim 3, wherein a content of the filler in the protective layer satisfies a range of 35 wt% to 85 wt%.

5. The antenna substrate of claim 1 or 2, wherein the circuit layer includes a plurality of antenna unit disposed on the insulating layer and spaced apart from each other, and
wherein two antenna units adjacent to each other among the plurality of antenna units are spaced apart from each other by a distance between 0.5 mm and 1.5 mm,

6. The antenna substrate of claim 5, wherein the plurality of antenna units are disposed alternately or zigzag on the insulating layer in a diagonal direction, and
wherein the distance is a separation distance in the diagonal direction between two antenna units arranged adjacent to each other.

7. The antenna substrate of claim 1 or 2, wherein the protective layer includes:
a first region overlapping the circuit layer in a thickness direction; and
a second region excluding the first region, and
wherein a thickness of the first region of the protective layer satisfies a range of 5 µm to 25 µm.

8. The antenna substrate of claim 7, wherein an upper surface of the first region of the protective layer has a same height as the upper surface of the second region of the protective layer.

9. The antenna substrate of claim 7, wherein an upper surface of the first region of the protective layer has a step from an upper surface of the second region of the protective layer.

10. An antenna substrate comprising:
an insulating layer;
a circuit layer disposed on the insulating layer;
a first protective layer disposed on the insulating layer; and
a second protective layer disposed on the circuit layer,
wherein the first protective layer has a first permittivity,
wherein the second protective layer has a second permittivity greater than the first permittivity, and
wherein the second permittivity has a range of 4 to 14 times that of the first permittivity.
